# EUROPEAN PATENT SPECIFICATION

(11) **EP 1 675 186 B1**
(45) Date of publication and mention of the grant of the patent: **22.08.2012**
(21) Application number: 04078478.7
(22) Date of filing: 22.12.2004
(51) Int. Cl.: H01L 31/032, H01L 31/18

(54) **Production process for a photovoltaic device**
Verfahren zur Herstellung einer Photovoltaikvorrichtung
Procédé pour produire des dispositifs photovoltaics

(43) Date of publication of application: 28.06.2006
(73) Proprietor: Thin Film Factory B.V., 8914 BH Leeuwarden (NL)
(72) Inventor: Meester, Bernhard, 2665 DR Bleiswijk (NL); Nanu, Marian, 3119 LE Schiedam (NL)
(74) Representative: van Westenbrugge, Andries

(56) References cited:
- US-A- 3 880 633
- TOMAR M S ET AL: "A ZnO/p-CuInSe2 thin film solar cell prepared entirely by spray pyrolysis" THIN SOLID FILMS, vol. 90, 1982, pages 419-423, XP008049221 ELSEVIER SEQUOIA, NL
- LENZMANN F ET AL: "Substantial improvement of the photovoltaic characteristics of TiO2/CuInS2 interfaces by the use of recombination barrier coatings" PREPARATION AND CHARACTERIZATION, ELSEVIER SEQUOIA, NL, vol. 451-452, 22 March 2004 (2004-03-22), pages 639-643, XP004495179 ISSN: 0040-6090
- SPIERING S ET AL: "CD-free Cu(In,Ga)Se2 thin-film solar modules with In2S3 buffer layer by ALCVD" PREPARATION AND CHARACTERIZATION, ELSEVIER SEQUOIA, NL, vol. 431-432, 1 May 2003 (2003-05-01), pages 359-363, XP004428667 ISSN: 0040-6090
- KIJATKINA O ET AL: "CuInS2 sprayed films on different metal oxide underlayers" PREPARATION AND CHARACTERIZATION, ELSEVIER SEQUOIA, NL, vol. 431-432, 1 May 2003 (2003-05-01), pages 105-109, XP004428615 ISSN: 0040-6090

## Description

### Field of the invention

The invention relates to a method for manufacturing a photovoltaic device comprising a plurality of layers, said plurality of layers comprising at least:
- a layer comprising a transparent material,
- a layer comprising an n-type doped material and
- a layer comprising a p-type doped material,
said layer comprising an n-type doped material being located in between said layer comprising a transparent material and said layer comprising a p-type doped material.

### Prior art

The production process of photovoltaic devices "PV's" or solar cells comprising layers of photoactive materials typically involves a variety of production processes inter-alia sputtering, vacuum co-evaporation, annealing, etching and chemical bath deposition.

The excellent performance of these photoactive materials provides solar cells with (almost) a theoretical conversion efficiency. Nevertheless, it will be clear from the previous list of production processes, that the technology involved is very demanding: relatively sophisticated and costly equipment is required. Further, the production processes are inherently time consuming, complex and expensive. Moreover, environmental issues affect the production processes as well, relative high losses of materials occur when using the abovementioned technologies. Also, the materials used for layers in solar cells may involve toxic components such as selenium (Se) and cadmium (Cd).

During the last years, it has shown that interest in thin film photovoltaic devices based on semiconductors with a chalcopyrite crystal structure, such as Cu(In,Ga)(Se,S)₂ is growing. Solar cells based on chalcopyrite semiconductors as photoactive materials may have a conversion efficiency of up to 17%.

One member of the chalcopyrite family is CuInS₂ (also: CIS), which has properties favorable for use as photoactive layer in solar cells: the conversion efficiency of CIS is more than 12%. Again, production processes for solar cells comprising CIS suffer from some serious disadvantages such as relatively high energy consumption of the sputter and evaporation processes, relatively slow deposition rates and long waiting times for pumping and flushing as are required by these processes.

Moreover, in the prior art, the throughput in number of produced photovoltaic devices per unit of time is relatively low, inherent to the limitation of batch quantities for production processes conducted in vacuum. The presently available solar cells are therefore expensive as well.

US 3,880,633 A discloses a method of making low cost solar cells on a large scale basis by means of a continuous process of fabricating float glass and coating the float glass, in sequence, with tin oxide, cadmium sulphide, and copper sulphide, while the glass floats atop tanks of molten material in a furnace of proper temperature for each step of the process. The application of the coatings is accomplished by depositing materials which form the coatings on contact with heated surfaces at such slow rates and, in the case of spray application, via drops of such uniformity that the float glass may remain at uniform temperatures.

### Summary of the invention

The present invention seeks to provide a production process for photovoltaic devices that is relatively cheap, simple and fast in comparison to the prior art.

Moreover, the present invention seeks to provide a production process which may be regarded as environmentally less aggravating.

The invention relates to a method as defined by claim 1.

Electrostatic spray deposition enables all layers to be deposited at atmospheric pressure in an ambient atmosphere. Advantageously, the requirement for vacuum based technologies can be dropped. Solar cells can be produced fully by the method of the present invention. As will be discussed later, such solar cells produced in accordance with the invention have comparable properties as solar cells from the prior art. The method according to the invention also offers the possibility to produce the layers without a cooling down step.

In an embodiment the invention is characterized by using a roll to roll process. This makes it possible to sequentially produce the photovoltaic device. In a roll-to-roll process, the substrates are heated on a conveyer belt furnace, which is divided in 6 deposition chambers.

The basic principle of spray deposition is the generation of an aerosol out of a solvent that contains the precursors followed by a precipitation of the aerosol. The generated droplets precipitate onto a heated substrate or substrate layer. After the solvent evaporates a thin film remains and solidifies on the substrate. The substrate is not spray deposited and comprises for instance a metal plate or a glass. However, the subsequent layers, are successively deposited one on top of the other.

The formation of the thin film from the precursors may be based on a physical reaction (e.g. solidification by evaporation of the solvent) and/or a chemical reaction involving the precursors.

In a common Spray Deposition set-up, the aerosol is formed by mechanical force (pressure or ultrasonic). By contrast, in electrostatic spray deposition (ESD) an electrostatic field induces the formation of the aerosol.

According to the invention, after electro-spray depositing a first layer and solidifying it, a next layer, with a different composition can be formed in a similar way. After the next layer is solidified, the process can be repeated. In a preferred embodiment, a stack of layers, comprising at least six layers can be produced, as will be illustrated in more detail in the description of the embodiments.

It should be pointed out that ESD is not the same as electro-spraying, which is widely used in the paint industry. In electro-spraying, a mechanical force forms a spray. Next, the droplets are charged, by applying a bombardment of ionized molecules. This method offers the possibility to charge highly insulating materials. In ESD, however, direct charging forms the spray.

### Brief description of drawings

The invention will be explained in more detail below with reference to a few drawings in which illustrative embodiments thereof are shown. They are intended exclusively for illustrative purposes and not to restrict the inventive concept, which is defined by the claims.
Figure 1 shows diagrammatically a solar cell in a cross-section,
Figure 2 shows diagrammatically a first configuration of a solar cell in a cross-section,
Figure 3 shows diagrammatically a second configuration of a solar cell in a cross-section,
Figure 4 shows an example of a production method,
Figure 5-7 show subsequent process steps during production of a solar cell,
Figure 8 shows an embodiment of a production method according to the present invention, and
Figure 9 shows a photocurrent-voltage characteristic of a spray deposited solar cell.

### Brief description of preferred embodiments

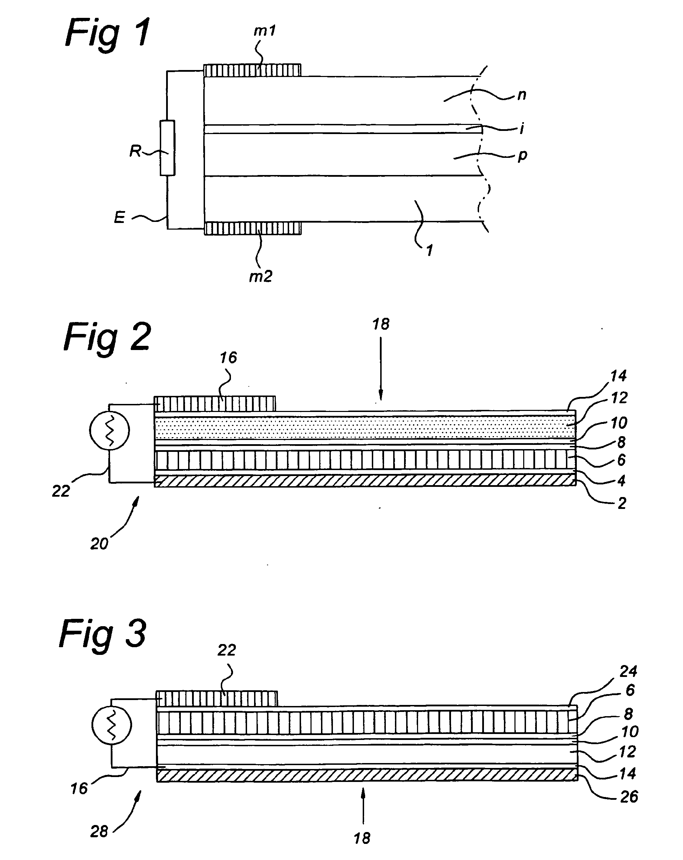

Figure 1 shows diagrammatically a solar cell in a cross-section.

A solar cell or PV is based on a p-n or p-i-n junction made in a semiconductor arrangement. Here the configuration of a p-i-n junction is shown. The junction has a first region (p) of a p-type material, a second region (n) of an n-type material, and optionally as intermediate of the p-type and n-type materials, a third region (i) of intrinsic or buffer material. The latter may be Al₂O₃, which is an insulator. In this material the tunneling effect appears. To complete the cell on both sides contacts ml, m2 of a conductive material are required.

In use, in one region of the junction (either p or n) charge carriers are generated by interaction of impinging light and the material (p-type, respectively, n-type). The solar cell is capable of externally conducting the generated charge carriers through a "back - contact" BC, see figure 1, on the photoactive top layer from one of the p or n regions to the respective other region.

The externally conducted charge through the back contact may provide electric power to an electric device, shown in figure 1 as a resistive element R, for instance a lamp that is included within an external circuit E.

The semiconductor arrangement of the solar cell of figure 1 comprises a sequence of layers deposited on top of each other to form the required junction. A substrate 1 is provided as a support for the layers forming the junction of the photoactive cell. In some cases, the substrate may be part of the junction as either the p-type or n-type region.

The substrate 1 will generally be conducting, and the p-type layer will be deposited on top of the substrate 1. The n-type layer will be deposited on the p-type layer. It is however also an option to produce the solar cell starting with a transparent glass as substrate. The position of the p-type layer and the position of the n-type layer will in this case be swapped, i.e. the p-type layer will be at the position of the n-type layer in figure 1 and vice versa. The contact m2, in this case will be positioned in such a way that it is in contact with the n-type layer, or, alternatively, an additional conducting layer will be applied in between the n-type layer and the glass substrate 1.

Two configurations of photovoltaic devices may be produced by the method of this invention. A first configuration ("configuration 1") is produced by using successive (electrostatic) spray deposition of a layer on a substrate or starting layer comprising a conducting plate/sheet, a layer comprising a p-type semiconductor, a first sub layer comprising a buffer, a second sub layer comprising a buffer, a layer comprising a n-type semiconductor and a layer comprising a transparent conductive oxide. Back contacts are made from conventional materials (metal), with conventional methods. This first configuration is explained in connection with figure 2.

A second configuration ("configuration 2") is produced by using successive (electrostatic) spray deposition of a layer comprising a transparent conductive oxide on a substrate or starting layer comprising a float glass substrate, a layer comprising a n-type semiconductor, a second sub layer comprising a buffer, a first sub layer comprising a buffer, a layer comprising a p-type semiconductor, a buffer layer and a layer comprising a metal film. This second configuration is explained in connection with figure 3.

A fully sprayed solar cell 20 in the first configuration is shown in figure 2. The solar cell 20 consists of a first layer 2 such as a metal plate or sheet 2, a layer 4 as a buffer to improve electron transport to the metal sheet 2, a layer 6 comprising a p-type semiconductor layer 6, a first sub layer 8 as buffer layer to prevent (interface and back) recombination, a second sub layer 10 as buffer layer to prevent copper diffusion into the p-type semiconductor layer 6, a layer 12 comprising n-type semiconductor and a layer 14 comprising a transparent conductive oxide. Finally, the solar cell 20 is supplied with a metal front contact 16. The metal plate 2 is in contact with a back contact 22. Photons impinge on the solar cell 20 along the direction indicated by an arrow 18. The solar cell 20 is build starting with the metal sheet 2 and applying successively by (electrostatic) spray deposition the layer 4, 6, 8, 10, 12 and 14.

In the example of Figure 2, first a metal buffer layer 4 is deposited on a metal plate or sheet 2 and subsequently the p-type layer 6 is deposited on the buffer layer 4. Next, the one or two further buffer sub layers 8 and 10 are deposited. Then, the n-type semiconductor layer 12 is deposited. On the n-type layer 12, the transparent conductive layer 14 is deposited. On the top of the transparent conductive oxide 14 a grating metal front contact 16 is formed using a conventional method. Finally, a last layer, usually Al₂O₃ as an anti reflective coating is formed. The metal plate or sheet 2 is used as a second back contact 22. The first grating metal front contact 16 and the second metal back contact 22 are externally connected in order to provide a conduction path for electrons from the p-type layer 6 to the n-type layer 12, with a recombination of charge carriers at the junction.

The p-type and n-type material of layer 6 and layer 12 respectively comprise the respective electronic properties of a semiconductor with acceptor and donor levels.

It is noted that dependent on the nature of the p-type and/or n-type layers as used one or more buffer layers are required to prevent spontaneous recombination of the electrons at the interface and/or to prevent diffusion of the elements of one of the semiconductors into the other.

In the solar cell 20, it is noted that the electronic properties of the p-type and/or n-type region may be tuned ("band gap engineered") for a desired sensitivity of the solar cell to a particular range of the electro-magnetic spectrum.

Various types of solar cells are known:
Silicon is used to construct a photoactive junction in a single material (homojunction) whereas recent developments have also led to creation of p-n junctions between two different semiconductors (heterojunctions). It is noted that the use of thin film (electrostatic) spray deposition technology for heterojunctions in this respect benefits from low material consumption and low price compared to the manufacturing of solar cells having crystalline silicon homojunctions.

Figure 3 shows the second configuration of a fully sprayed solar cell 28. In figure 3, reference numerals equal to reference numerals in figure 1 refer to the same parts. In contrast to the first configuration of figure 1, the cell 28 is build from the side facing the sun, as indicated by the arrow 18. The solar cell 28 in the second configuration of the present invention consists of a float glass substrate 26, a layer 14 comprising a transparent conductive oxide layer, an optional buffer layer (not shown in figure 3) to improve the electron transport to the transparent conductive oxide layer 14, a layer 12 comprising an n-type semiconductor layer, a second sub layer 10 comprising buffer material to prevent recombination, a first sub layer 8 comprising buffer material to prevent diffusion of atoms in the p-type semiconductor layer 6, a layer comprising a p-type semiconductor layer 6 and a conducting layer 24. Finally, the solar cell is supplied with metal front contacts 16 and back contacts 22.

Thus, in the case of figure 3, sequentially a transparent conductive oxide layer 14, an n-type layer 12, a second sub layer 10 and a first sub layer 8, a third p-type layer 6 and finally a conductive film layer 24 are deposited.

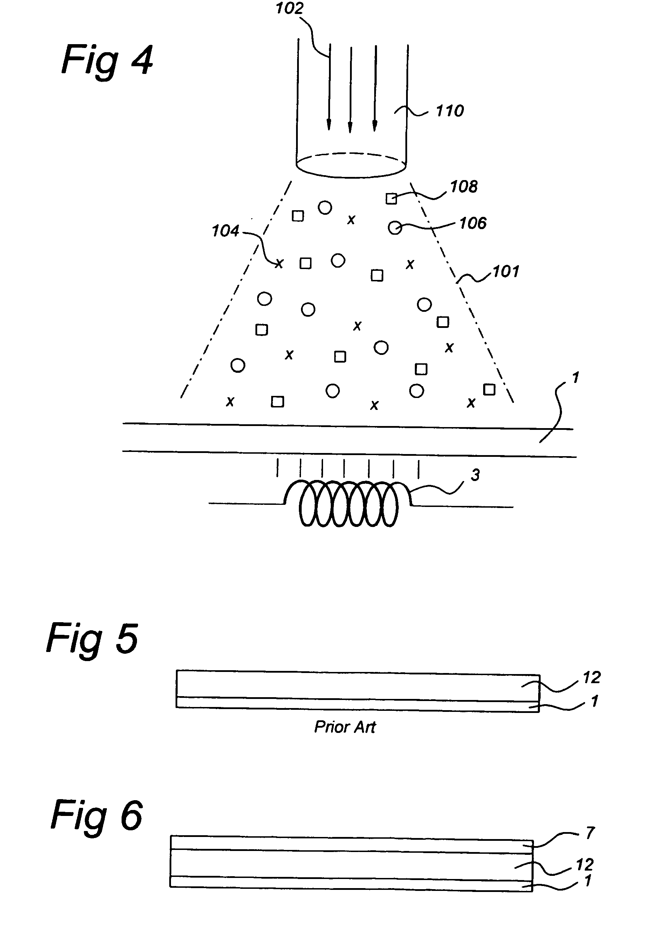

Figure 4 shows an example of a production process of a fully sprayed solar cell. In this example, spray deposition is used to construct the complete semiconductor layer stack on a substrate 1. This example may also be carried out in a so called roll-to-roll process.

A substrate 1 is located on a substrate table (not shown) which may be heated with a heater 3. In the case of a roll-to-roll process the substrate table may be replaced by a conveyer belt furnace. The substrate 1 may comprise a metal, a float glass, or a conductive polymer. During deposition of the layers the substrate 1 is typically heated to a temperature of between 200 °C and 450 °C.

An outlet or nozzle 110 is located at some distance above the substrate 1 and is capable of supplying a solution 102 which contains a solvent and one or more precursors. When processing, the solution 102 leaves the outlet 110, and an aerosol 101 (i.e., a dispersion of liquid droplets in gas) is generated, the aerosol 101 comprising the solvent and precursors.

In figure 4 this is illustrated for an aerosol comprising three precursors, although the principle applies equally well to one or more precursors other than three. For instance, one precursor in a first production step, three in a second step, one in a third step, two in a fourth step, one in a fifth step and two in a sixth step. In figure 4, one precursor is represented by crosses 104, another precursor is represented by circles 106 and another by squares 108. Deposition of each layer is preferably carried out in an inert ambient atmosphere.

Below, the first configuration as shown in figure 2 will further be elaborated. In order to produce in a first process step the buffer layer 4, in figure 2, for example molybdenum, the precursor may comprise at least one of the following: molybdenum halides, molybdenum alkyl compounds, molybdenum alkoxides, molybdenum β-diketonato complexes, molybdenum cyclopentadienyl compounds, molybdenum hydrides and molybdenum alkylamides.

The solvent may comprise at least one of the following: alcohols, ethers, aldehydes, ketones, esters and water.

In order to produce the layer comprising a p-type semiconductor 6 in a second step, see the above, for example CuInS₂ (CIS), the copper precursor may comprise at least one of the following: copper halides, copper alkyl compounds, copper alkoxides, copper β-diketonato complexes, copper cyclopentadienyl compounds, copper hydrides and copper alkylamides. An indium precursor may comprise at least one of the following: indium halides, indium alkyl compounds, indium alkoxides, indium β-diketonato complexes, indium cyclopentadienyl compounds, indium hydrides and indium alkylamides. And a third precursor may be a sulfur precursor comprising at least one of the following: thiourea [(NH₂)₂CS], tert-butyl disulfide [(C₈H₁₈S₂)] and CS₂, Na₂S or [(NH₂)₂CSe] for Se. The solvent may comprise at least one the following: alcohols, ethers, aldehydes, ketones, esters and water.

In order to produce the first sub layer 8 in a third step, In₂S₃ for example, the indium precursor may comprise the following: indium halides, indium alkyl compounds, indium alkoxides, indium β-diketonato complexes, indium cyclopentadienyl compounds, indium hydrides and indium alkylamides. The sulfur precursor may comprise at least one of the following: thiourea [(NH₂)₂CS], tert-butyl disulfide [(C₈H₁₈S₂)] and CS₂. The solvent may comprise the following: alcohols, ethers, aldehydes, ketones, esters and water.

In order to produce the second sub layer 10 in a fourth step, for example Al₂O₃, an aluminum precursor may comprise the following: aluminum halides, aluminum alkyl compounds, aluminum alkoxides, aluminum β-diketonato complexes, aluminum cyclopentadienyl compounds, aluminum hydrides and aluminum alkylamides. The solvent may be comprises at least one of the following: alcohols, ethers, aldehydes, ketones, esters, water.

In order to produce the n-type semiconductor 12 in a fifth step, TiO₂ for example, a titanium precursor may comprise the following: titanium halides, titanium alkyl compounds, titanium alkoxides, titanium β-diketonato complexes, titanium cyclopentadienyl compounds, titanium hydrides and titanium alkylamides. The solvent may be comprise at least one of the following: alcohols, ethers, aldehydes, ketones, esters, water.

In order to produce the transparent conductive oxide 14 in a sixth step, for example Al-doped ZnO, the aluminum precursor may comprise the following: aluminum halides, aluminum alkyl compounds, aluminum alkoxides, aluminum β-diketonato complexes, aluminum cyclopentadienyl compounds, aluminum hydrides and aluminum alkylamides. A zinc precursor may comprise the following: zinc halides, zinc alkyl compounds, zinc alkoxides, zinc β-diketonato complexes, zinc cyclopentadienyl compounds, zinc hydrides and zinc alkylamides. The solvent may comprise at least one of the following: alcohols, ethers, aldehydes, ketones, esters, water and pyrogalol.

The flow of the aerosol 101 is directed towards the substrate 1 during all deposition steps. After traversing the distance between nozzle 110 and substrate the constituents of the aerosol contact the surface of the substrate 1.

The solvent from solution 102 is evaporated from the substrate, which has a relatively high temperature due to heating by the heater 3.

Precursors from the successive production steps will react to form successive layers of molybdenum, CuInS₂, In₂S₃, Al₂O₃, TiO₂, and Al-doped ZnO on the substrate 1. Typically, the conditions during formation of the materials are such that a thin film (or layer) is formed.

The process described in connection with figure 4 is called spray deposition.

Typically, a solar cell contains a semiconductor junction, which shows n-type conductivity for electron transport, buffer layers (optionally), and a p-type semiconductor for hole conduction. Using spray deposition all the components of the solar cell can be manufactured.

Moreover, in the present invention, instead of the relative expensive F-doped SnO₂ TCO glass substrate as explained above, a relative cheap metal plate or sheet or any other conductive material, preferably Cu, Mo, Ti may be used as the substrate 1, since the requirements related to deposition are less severe for spray deposition than for vacuum based deposition techniques.

In the above figure 4, the process of producing a solar cell according to this example is explained in detail. More generally, the production of such a device will be described with reference to figures 5, 6 and 7.

In figure 5, a thin film 12 consisting of CuInS₂ on the substrate 1 is shown. The substrate 1 acts in support of the solar cell and may for instance comprise copper (in this case layer 12 will be a p type layer) or transparent glass (in this case the layer 12 will be an n-type layer).The thin film 12 may comprise CuInS₂ crystals up to 300 nm in size with a preferred orientation along the (112) crystallographic direction. Such a solar cell comprising a film 12 deposited on a substrate 1 is known in the prior art. However, such a solar cell shows a relatively poor photovoltaic behavior. Also, the efficiency of these solar cells is relatively low, e.g. typically 1-2%. The best result is around 1% for such a cell. Note that such a cell is not fully spray deposited. Only one of the layers is spray deposited.

Then, in figure 6, the next process step is shown. In this subsequent process step, a further layer or film 7 of a photoactive material (in case of a previously deposited n-type layer this is a p-type layer or vice versa) is deposited on the thin film 12 of TiO₂ that is already present. The layer 7 is deposited by spray deposition as explained above in connection with figures 2 and 3. The layer 7 is preferably a CuInS₂ film with a thickness of around 2 micron.

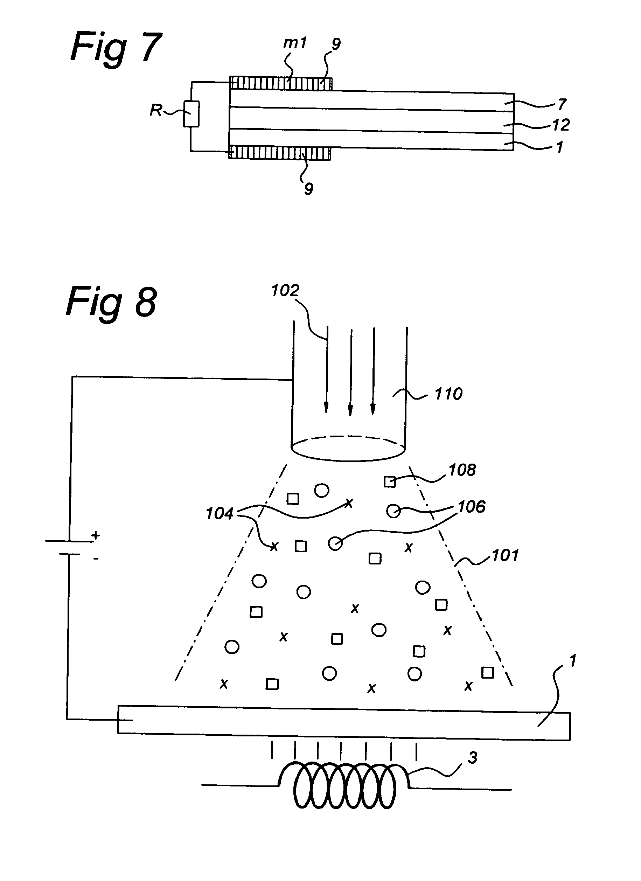

Figure 7 shows the next process step. In this step, back contacts 9 are, by means of evaporation, applied on the solar cell to provide means for supplying, at a later stage, electric power to some external electric device. The back contacts 9 are, for instance, made of copper or aluminum, but other conducting materials may be suitable as well.

The materials that can be used in the solar cell made completely by spray deposition are various.

For n-type layer 12 one or more of the following compounds may be used: ZnO, TiO₂, BaTiO₃, In₂O₃, In₂S₃, In₂(OH)S₂, ZnS, ZnSe, CdS.

For a buffer or intrinsic (sub) layer 8, 10 may be used, one or more of the compounds In₂O₃, In₂S₃, In₂(OH)S₂, Al₂O₃, ZnS, ZnSe, CdS, ZnO, MgO, InS₂.

And for p-type layer 6 one or more of the compounds CuInS₂, CuInSe₂, CuInGaS₂, CuInGaSeS₂, CdTe, MoS₂, FeS₂ may be used.

Also, so-called III-V semiconductors, like GaAs, InAs, InP, etc. along with their ternary and quaternary alloys may be used in solar cells manufactured by spray deposition. Moreover, suitable sulfur-, selenium-, and tellurium-based semiconductors may be used.

The present invention provides an alternative spray deposition method, in which the spray deposition is electrically enhanced. Figure 8 shows the principle of aerosol generation by ESD.

Whereas with spray deposition the force driving solution 102 and the aerosol 101 with the precursors 104, 106 and 108 see figure 4 is mechanical, the present invention also envisages the application of electrostatic spray deposition (ESD).

ESD employs an electrostatic field between the outlet nozzle 110 and the substrate 1 which influences the drift of the aerosol to the substrate 1. This ESD process is explained in connection with figure 8.

In Electrostatic Spray Deposition (ESD) an electrostatic field induces the formation of the aerosol. It should be pointed out that ESD is not the same as electro-spraying, which is widely used in the paint industry. In electro-spraying a mechanical force forms a spray. Next, the droplets are charged, by applying a bombardment of ionized molecules. This method offers the possibility to charge highly insulating materials. In ESD, however, direct charging forms the spray.

After the aerosol is generated by means of electrostatic forces, the electric field that is applied between the nozzle and the grounded substrate, accelerates the charged droplets towards the substrate. Since the substrate is heated (typically between 150 and 450 °C), the liquid droplets solidify as a result of solvent evaporation. Several processes occur during flight of the droplets and after impingement of the droplets or nanocrystals onto the substrate surface, which determine the morphology of the deposited films. The following processes are involved: droplet drying, solute precipitation and crust formation, preferential landing of charged droplets, discharging and spreading of the droplets, and possible reaction of the remaining solutions.

The electrostatic field induces a surface charge in the cone surface, which mainly consists of ions. The tangential electric field accelerates the ions towards to the cone apex. These ions accelerate the surrounding liquid. As a result, a liquid jet emerges at the cone apex. The acceleration processes and the shape of the liquid cone are a result of the balance between viscosity, surface tension, gravity, and electrical stress at the liquid surface. After the aerosol is generated by means of electrostatic forces, the electric field that is applied between the nozzle and the grounded substrate accelerates the charged droplets towards the substrate.

In figure 8 entities which correspond to similar entities as shown in the preceding figure 4 will have the same reference number. Their description will be omitted here. In figure 5, the outlet nozzle 110 is connected to a high voltage source 114. The high voltage source 114 also provides a connection to the substrate 1.

In use, spherical droplets containing precursors and solvent 102 are formed at the outlet 110. The droplets are charged because they are, via the outlet 110, in contact with the high voltage source 114.

A voltage of preferably 6-30 kV is applied between the outlet nozzle 110 and the substrate 1. Exposed to this voltage, a droplet from the nozzle 110 adopts a conical shape and atomizes to form a spray of spray droplets with a substantially uniform spray droplet size. Moreover, the spray droplets are charged electrostatic. Driven by the electrostatic forces between them, the spray droplets spread out evenly in space. Due to charging of the spray a highly uniform spray droplet distribution is obtained. This results in a substantially uniform deposition (rate) on the substrate.

The aerosol 101 may leave the outlet 110 in one of a variety of modes, each caused by one of many different electro-hydrodynamic states that can be active.

As is the case for the embodiment shown in figure 4, this embodiment may also be carried out in a so called roll-to-roll process.

The advantages of ESD compared to spray deposition are various:
Due to acceleration of the spray droplets the precursors will reach the substrate 1 in a relatively short period of time. This enables relatively fast deposition rates.

Again, two configurations of solar cells are produced by the method of the present invention.

The first configuration (figure 2) is produced by successive electrostatic spray deposition on the first layer 2 comprising a conducting plate/sheet of the fourth layer 4 comprising a buffer layer, the second layer 6 comprising a p-type semiconductor, the first buffer sub layer 8, a second buffer sub layer 10, the third layer 12 comprising the n-type semiconductor and the sixth layer 14 comprising transparent conductive oxide. Back contacts 22 are made from conventional materials (a metals), with conventional methods.

The second configuration (figure 3) is produced by electrostatic spray deposition on the first layer 26 comprising a float glass substrate of fourth layer 14 comprising a transparent conductive oxide, the second layer 12 comprising n-type semiconductor, a second buffer sub layer 10, the first buffer sub layer 8, the third layer 6 comprising a p-type semiconductor, the third buffer layer and the sixth layer comprising a metal film 24.

It is noted that the electric field required for spray generation, may affect the temperature required for the chemical reaction (rate of the growth of a layer), which also may lead to lower deposition.

By using the production process shown in figure 4 and 8, a simple and relatively low cost production of a solar cell is provided. All steps can be done under atmospheric pressure, without any extreme requirements as related to the vacuum processing methods known from the prior art.

By using the processing steps shown in Figure 4, a simple and relatively low cost production process for solar cells is provided. All steps can be done under atmospheric pressure, without any extreme requirements as related to the vacuum processing methods known from the prior art.

Another important feature of ESD is that it combines a high deposition rate and a lower deposition temperature with an excellent control over the morphology, crystal structure and stoichiometry of the deposited films, by means of the accelerating voltage from the high voltage source 114. Under circumstances the control of the material properties by the acceleration voltage may be combined with one or more deposition parameters relating to the fluxes of precursors and the temperature of the substrate 1.

The control of the growth can influence the morphology of the deposited layers. For example, deposition of homogeneous smooth films and of (nano)porous films is possible. Also, (avoidance of the) occurrence of cracks in the films may be controllable.

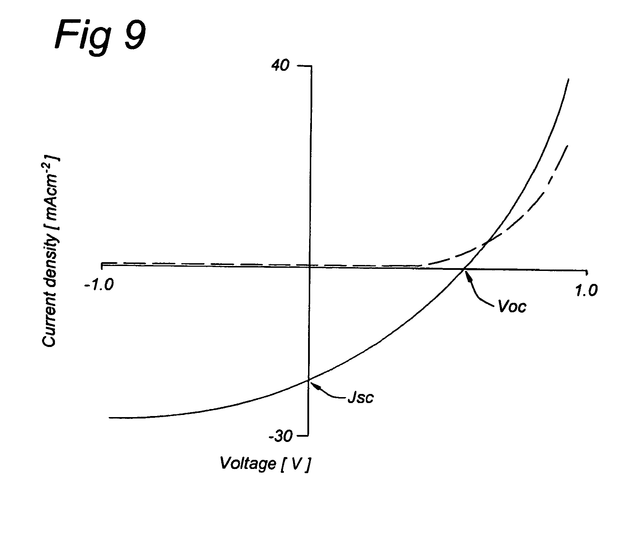

Figure 9 shows the photocurrent-voltage characteristic of a fully spray deposited solar cell. The dashed line represents a photocurrent-voltage characteristic measured in the absence of light (in darkness). The solid line represents a photocurrent-voltage characteristic measured in the presence of a defined amount of light. The intersection of the solid line with the vertical voltage axis determines the maximum current which can be delivered per unit area: Jsc. The intersection of the solid line with the horizontal current density axis determines the open cell voltage: Voc. Both Jsc and Voc are shown in figure 9. For the solar cell shown in figure 9, Jsc = 20 mA/cm², Voc = 0,7 V and FF = 0,42. It can be shown that this solar cell has an efficiency of around 5,7 %.

## Claims

1. Method for manufacturing a photovoltaic device (20; 28) comprising on a substrate (1; 2; 26) a plurality of layers, said plurality of layers comprising at least:
- a layer comprising a transparent conductive material (14),
- a layer comprising an n-type doped material (12) and
- a layer comprising a p-type doped material (6),
said layer comprising an n-type doped material (12) bering located in between said layer comprising a transparent conductive material (14) and said layer comprising a p-type doped material (6), using electrostatic spray deposition (ESD) for applying said plurality of layers, wherein electrostatic spray deposition employs an electrostatic field to induce the formation of an aerosol (101), **characterized by** electrostatic direct charging droplets from a nozzle (110) connected to a high voltage source (114) to atomize for forming a spray; the high voltage source also providing a connection to the substrate; with an acceleration voltage from the high voltage source between the nozzle and the substrate;
for each layer of said plurality of layers said deposition comprising:
• generating the aerosol (101) comprising solvent (102) and precursors (104, 106, 108);
• directing a flow of the aerosol towards the substrate, the constituents of the aerosol contacting the surface of the substrate;
• evaporating the solvent from the substrate;
• the precursors reacting to form the layer,
wherein the acceleration voltage between nozzle and substrate provides control over the morphology, crystal structure and stoichiometry of the deposited layers.

2. Method according to claim 1, **characterized by** applying a layer comprising a conductive material (24) over said layer comprising a p-type doped material (6).

3. Method according to any one of the preceding claims, **characterized by** using electrostatic spray deposition for applying at least a layer comprising an intrinsic or buffer material (8; 10) to prevent recombination or diffusion in between said layer comprising an n-type doped material (12) and said layer comprising a p-type doped material (6).

4. Method according to any one of the preceding claims, comprising a formation of a grating metal contact (16) on top of said layer comprising transparent conductive material.

5. Method according to any one of the preceding claims **characterized by** using a roll-to-roll process.

6. Method according to any one of the preceding claims, said plurality of layers comprising:
- a layer comprising at least one of a set comprising a transparent conductive oxide (TCO) glass, a metal plate, polyethyleentereftalaat (PET) and a conductive polymer,
- a layer comprising at least one of a set comprising ZnO, TiO₂, BaTiO₃, In₂O₃, In₂S₃, In₂(OH)S₂, ZnS, ZnSe, CdS, and MgO,
- a layer comprising at least one of a set comprising CuInS₂, CuInSe₂, CuInGaS₂, CuInGaSeS₂, CdTe, MoS₂, and FeS₂,
- a layer comprising a first sub layer and a second sub layer, said first sub layer being located in between said layer comprising a p-type doped material and said second sub layer, said second sub layer being located in between said first sub layer and said layer comprising an n-type doped material, said first sub layer and said second sub layer comprising at least one of a set comprising In₂O₃, In₂S₃, In₂(OH)S₂, Al₂O₃, ZnS, ZnSe and CdS, and
- a layer comprising at least one of a set comprising copper, aluminum, tungsten, molybdenum, a transparent conductive oxide (TCO) glass, a metal plate, polyethyleentereftalaat (PET) and a conductive polymer.

## Patentansprüche

1. Verfahren zur Herstellung einer Photovoltaikvorrichtung (20; 28), umfassend auf einem Substrat (1; 2; 26) eine Mehrzahl von Schichten, wobei die Mehrzahl von Schichten wenigstens umfasst:
- eine Schicht, die ein transparentes leitfähiges Material (14) umfasst,
- eine Schicht, die ein n-Typ-dotiertes Material (12) umfasst, und
- eine Schicht, die ein p-Typ-dotiertes Material (6) umfasst,
wobei die Schicht, die ein n-Typ-dotiertes Material (12) umfasst, sich zwischen der Schicht, die ein transparentes leitfähiges Material (14) umfasst, und der Schicht, die ein p-Typ-dotiertes Material (6) umfasst, befindet, unter Anwendung von elektrostatischer Sprühabscheidung (ESD) zum Auftragen der Mehrzahl von Schichten, wobei die elektrostatische Sprühabscheidung ein elektrostatisches Feld verwendet, um die Bildung eines Aerosols (101) zu bewirken, **gekennzeichnet durch** elektrostatisches direktes Aufladen von Tröpfchen aus einer mit einer Hochspannungsquelle (114) verbundenen Düse (110) zur Zerstäubung zur Bildung eines Sprays, wobei die Hochspannungsquelle auch eine Verbindung zum Substrat besitzt mit einer Beschleunigungsspannung von der Hochspannungsquelle zwischen der Düse und dem Substrat,
wobei für jede Schicht der Mehrzahl von Schichten die Abscheidung umfasst:
• Erzeugen eines Aerosols (101), das Lösungsmittel (102) und Vorläufer (104; 106; 108) umfasst,
• Richten eines Aerosolstroms auf das Substrat, wobei die Bestandteile des Aerosols die Oberfläche des Substrats kontaktieren,
• Verdampfen des Lösungsmittels vom Substrat,
• Reagierenlassen der Vorläufer unter Bildung der Schicht,
wobei die Beschleunigungsspannung zwischen der Düse und dem Substrat die Steuerung der Morphologie, Kristallstruktur und Stöchiometrie der abgeschiedenen Schichten ermöglicht.

2. Verfahren gemäß Anspruch 1, **gekennzeichnet durch** Auftragen einer Schicht, die ein leitfähiges Material (24) umfasst, über der Schicht, die ein p-Typ-dotiertes Material (6) umfasst.

3. Verfahren gemäß einem der vorhergehenden Ansprüche, **gekennzeichnet durch** Anwendung von elektrostatischer Sprühabscheidung zum Auftragen von wenigstens einer Schicht, die ein intrinsisches oder Puffermaterial (8; 10) umfasst, um die Wiedervereinigung oder Diffusion zwischen der Schicht, die ein n-Typ-dotiertes Material (12) umfasst, und der Schicht, die ein p-Typ-dotiertes Material (6) umfasst, zu verhindern.

4. Verfahren gemäß einem der vorhergehenden Ansprüche, umfassend eine Bildung eines Crittermetallkontakts (16) über der Schicht, die transparentes leitfähiges Material umfasst.

5. Verfahren gemäß einem der vorhergehenden Ansprüche, **gekennzeichnet durch** Anwendung eines Rolle-zu-Rolle-Verfahrens.

6. Verfahren gemäß einem der vorhergehenden Ansprüche, wobei die Mehrzahl von Schichten umfasst:
- eine Schicht, die wenigstens eines aus einer Gruppe, umfassend ein transparentes leitfähiges Oxid-Glas (TCO-Glas), eine Metallplatte, Polyethylenterephthalat (PET) und ein leitfähiges Polymer, umfasst,
- eine Schicht, die wenigstens eines aus einer Gruppe, umfassend ZnO, TiO₂, BaTiO₃, In₂O₃, In₂S₃, In₂(OH)S₂, ZnS, ZnSe, CdS und MgO, umfasst,
- eine Schicht, die wenigstens eines aus einer Gruppe, umfassend CuInS₂, CuInSe₂, CuInGaS₂, GuInGaSeS₂, CdTe, MoS₂ und FeS₂, umfasst,
- eine Schicht, die eine erste Teilschicht und eine zweite Teilschicht umfasst, wobei sich die erste Teilschicht zwischen der Schicht, die ein p-Typ-dotiertes Material umfasst, und der zweiten Teilschicht befindet und sich die zweite Teilschicht zwischen der ersten Teilschicht und der Schicht, die ein n-Typ-dotiertes Material umfasst, befindet, wobei die erste Teilschicht und die zweite Teilschicht wenigstens eines aus einer Gruppe, umfassend In₂O₃, In₂S₃, In₂(OH)S₂, Al₂O₃, ZnS, ZnSe und CdS, umfassen, und
- eine Schicht, die wenigstens eines aus einer Gruppe, umfassend Kupfer, Aluminium, Wolfram, Molybdän, ein transparentes leitfähiges Oxid-Glas (TCO-Glas), eine Metallplatte, Polyethylenterephthalat (PET) und ein leitfähiges Polymer, umfasst.

## Revendications

1. Un procédé de préparation d'un dispositif photovoltaïque (20; 28) comprenant, sur un substrat (1; 2; 26) une pluralité de couches, cette pluralité de couches comprenant au moins :
- une couche comprenant un matériau conducteur transparent (14);
- une couche comprenant un matériau dopé de type n (12); et
- une couche comprenant un matériau dopé de type p (6),
ladite couche comprenant un matériau dopé de type n (12) étant disposée entre ladite couche comprenant un matériau conducteur transparent (14) et la couche comprenant un matériau dopé de type p (6), ladite pluralité de couches étant appliquée par dépôt par pulvérisation électrostatique (ESD), lequel dépôt par pulvérisation électrostatique faisant emploi d'un champ électrostatique pour produire la formation d'un aérosol (101), lequel procédé de préparation étant **caractérisé en ce que** des gouttes sont directement chargées par voie électrostatique par une buse d'injection (110) connectée à une source de tension élevée (114) produisant l'atomisation et la formation d'un jet; la source de tension élevée fournissant également une connexion au substrat; une tension d'accélération provenant de la source à tension élevée entre la buse et le substrat;
le dépôt par pulvérisation comprenant pour chaque couche de ladite pluralité de couches:
• la génération de l'aérosol (101) comprenant le solvant (102) et les précurseurs (104, 106, 108);
• l'envoi d'un flux de l'aérosol vers le substrat, les constituants de l'aérosol entrant en contact avec la surface du substrat;
• l'évaporation du solvant du substrat;
• les précurseurs réagissant pour former la couche,
procédé dans lequel l'accélération de la tension entre la buse et le substrat assure le contrôle de la morphologie, de la structure cristalline et de la stoechiométrie des couches déposées.

2. Procédé selon la revendication 1, **caractérisé par** l'application d'une couche comprenant un matériau conducteur (24) sur ladite couche comprenant un matériau dopé de type p.

3. Procédé selon l'une quelconque des revendications précédentes, **caractérisé en ce qu'**on utilise le dépôt par pulvérisation électrostatique pour appliquer au moins une couche comprenant un matériau intrinsèque ou tampon (8; 10) pour empêcher la recombinaison ou la diffusion entre ladite couche comprenant le matériau dopé de type n (12) et la couche comprenant le matériau dopé de type p.

4. Procédé selon l'une quelconque des revendications précédentes comprenant la formation d'un contact métallique en grillage (16) disposé sur ladite couche comprenant le matériau conducteur.

5. Procédé selon l'une quelconque des revendications précédentes **caractérisé en ce que** l'on applique un procédé opérant entre un rouleau dérouleur et un rouleau enrouleur.

6. Procédé selon l'une quelconque des revendications précédentes, ladite pluralité de couches comprenant :
- une couche comprenant au moins un ensemble comprenant un verre d'un oxyde conducteur transparent (TCO), une plaque métallique, du téréphtalate de polyéthylène (PET) et un polymère conducteur,
- une couche comprenant au moins un d'un ensemble comprenant ZnO, TiO₂, BaTiO₃, In₂O₃, In₂S₃, In₂ (OH)S₂, ZnS, ZnSe, CdS, et MgO,
- une couche comprenant au moins un ensemble comprenant CuInS₂, CuInSe₂, CuInGaS₂, CuInGaSeS₂, CdTe, MoS₂, et FeS₂,
- une couche comprenant une première sous couche et une seconde sous couche, ladite première sous couche étant située entre ladite couche comprenant un matériau dopé de type p et ladite seconde sous couche, ladite seconde sous couche étant situé entre ladite première sous couche et ladite couche comprenant un matériau dopé de type n, ladite première sous couche et ladite seconde sous couche comportant au moins un ensemble comprenant In₂O₃, In₂S₃, In₂(OH)S₂, Al₂O₃, ZnS, ZnSe et CdS, et
- une couche comprenant au moins un ensemble comprenant du cuivre, de l'aluminium, du tungstène, du molybdène, un verre d'oxyde conducteur transparent (TCO), une plaque métallique, du téréphtalate de polyéthylène(PET) et un polymère conducteur.
